# DEMANDE DE BREVET EUROPEEN

(11) **EP 3 010 312 A1**
(43) Date de publication de la demande: **20.04.2016**
(21) Numéro de dépôt: 15189407.8
(22) Date de dépôt: 12.10.2015
(51) Int. Cl.: H05B 33/08

(54) **PROCEDE DE PREVISION D'UNE DEFAILLANCE D'UNE DIODE ELECTROLUMINESCENTE**

(30) Priorité: 15.10.2014 FR 1459905
(71) Demandeur: Commissariat à l'Énergie Atomique et aux Énergies Alternatives, 75015 Paris (FR)
(72) Inventeur: HAMON, Benoit, 53150 Bree (FR)
(74) Mandataire: GIE Innovation Competence Group

(57) **Abrégé**

L'invention concerne un procédé de prévision d'une défaillance d'une diode électroluminescente (23), comprenant les étapes de :
-appliquer une différence de potentiel de test aux bornes de la diode électroluminescente inférieure à sa différence de potentiel minimale d'allumage, la différence de potentiel de test ayant le même signe que la différence de potentiel minimale d'allumage ;
-mesurer (5) le courant traversant I_{c} la diode électroluminescente (23) durant l'application de ladite différence de potentiel de test;
-générer un signal d'alerte lorsque le courant Ic mesuré dépasse un seuil d'alerte la.

## Description

L'invention concerne les éclairages à diodes électroluminescentes, et en particulier les méthodes permettant d'anticiper les défaillances de tels éclairages.

Du fait de ses avantages reconnus en termes de rendement énergétique, de compacité et de durée de vie, la technologie d'éclairage à diodes électroluminescentes ou LED connaît un développement commercial important. Les éclairages à diodes électroluminescentes sont donc particulièrement favorisés pour des sources lumineuses dont le remplacement est complexe, par exemple des feux de signalisation, des éclairages urbains ou des phares automobiles.

Comme la plupart des autres types de sources lumineuses, les diodes électroluminescentes sont confrontées à une dégradation de leur luminosité avec leur vieillissement. Parmi les applications mentionnées précédemment, des actions préventives sont généralement réalisées avant un dysfonctionnement complet des diodes électroluminescentes. Cependant, un tel remplacement préventif implique le changement d'un certain nombre de diodes électroluminescentes qui ont en fait une durée de vie relativement importante, pour tenir compte des diodes les plus défavorables. Par ailleurs, il est souhaitable de pouvoir déterminer directement sur une ligne de fabrication des diodes électroluminescentes défaillantes, afin de pouvoir les mettre immédiatement au rebut. Ainsi, il existe un besoin pour bénéficier d'un signal d'alerte lorsque la durée de vie résiduelle d'un éclairage devient relativement basse.

Un premier procédé connu pour anticiper une défaillance d'un éclairage, consiste à mesurer l'illumination des diodes électroluminescentes au moyen d'un capteur optique externe. Cependant, un tel procédé nécessite des composants supplémentaires difficiles à intégrer avec un substrat de diode électroluminescente et induisant ainsi un surcoût assez conséquent. De plus, un tel procédé doit être lui-même extrêmement fiable pour s'assurer que les modifications mesurées sont dues à la dégradation de la LED et non du système de mesure. L'utilisation d'un tel procédé présente donc des applications relativement limitées. Par ailleurs, de tels capteurs lumineux peuvent fausser la mesure lorsqu'ils reçoivent un flux lumineux provenant d'autres diodes électroluminescentes.

Le document EP2523008 décrit un procédé de détermination d'une durée de vie résiduelle d'une diode électroluminescente. Ce procédé consiste à analyser l'évolution de la résistance électrique de passage de la diode électroluminescente dans le temps. Chaque résistance de passage est déterminée en allumant la diode électroluminescente avec deux tensions d'alimentation différentes, en la faisant traverser par deux intensités différentes correspondantes. L'évolution de la résistance de passage est considérée comme représentative de la dégradation progressive du flux lumineux. La durée de vie résiduelle de la diode électroluminescente est donc déterminée en fonction de l'évolution de la résistance électrique de passage durant son allumage.

Ces procédés visent à anticiper un mode de défaillance basé sur une dépréciation lente du flux. Afin que les durées de vie prévisionnelles calculées sur la base de ce mode de défaillance soient réalistes, la plupart des normes de tests préconisent que les calculs de la durée de vie prévisionnelle soient menés sur la base de mesures après une durée significative d'utilisation d'une diode électroluminescente. D'après la méthode TM21-11 préconisée par IESNA IESNA utilisée dans l'industrie des LEDs, la durée de vie prévisionnelle ne peut être évaluée qu'avec un facteur 6 par rapport à la durée du test de fiabilité. Typiquement, pour 6000 heures de test, la durée de vie annoncée ne pourra pas dépasser 36000 heures. Ces calculs prévisionnels sont donc destinés à une estimation de durée de vie avant la distribution des produits, et non à une estimation de durée de vie en cours d'utilisation.

Le document WO2007/022409 décrit un procédé de test de diodes électroluminescentes. Le document propose de réaliser des tests de fonctionnement de diodes électroluminescentes durant leur extinction. A cet effet, un pont d'interrupteurs permet d'inverser la polarité d'une tension d'allumage d'une diode électroluminescente. Durant un test, la différence de potentiel appliquée aux bornes de la diode électroluminescente comporte la même amplitude que la différence de potentiel d'allumage mais une polarité opposée. Ce document ne permet cependant pas de réaliser un test de diode électroluminescente pour déterminer sa durée de vie avec une bonne fiabilité.

Le document EP2523008 propose de réaliser une détermination de durée de vie d'une diode électroluminescente. A cet effet, ce document propose d'appliquer successivement des différences de potentiel d'allumage différentes aux bornes de la diode électroluminescente. Pour ces différences de potentiel, le courant traversant la diode électroluminescente est mesuré. La caractéristique courant/tension de la diode électroluminescente est extrapolée des mesures, puis le vieillissement de la diode électroluminescente est déterminé à partir de cette caractéristique.

Le document US6147617 décrit un procédé de test du fonctionnement d'un afficheur publicitaire à diodes électroluminescentes. Ce procédé de test fournit une détermination relativement imprécise du fonctionnement des diodes électroluminescentes.

L'invention vise à résoudre un ou plusieurs de ces inconvénients. L'invention porte ainsi sur un procédé de prévision d'une défaillance d'une diode électroluminescente, tel que défini dans les revendications annexées.

L'invention porte en outre sur un dispositif d'éclairage, tel que défini dans les revendications annexées.

D'autres caractéristiques et avantages de l'invention ressortiront clairement de la description qui en est faite ci-après, à titre indicatif et nullement limitatif, en référence aux dessins annexés, dans lesquels :
- la figure 1 est une représentation schématique d'un exemple de système pour la génération d'un signal d'alerte lorsque la durée de vie résiduelle devient insuffisante ;
- la figure 2 est un diagramme illustrant un exemple d'évolution du courant de fuite par la diode électroluminescente en fonction de la tension d'alimentation et du temps ;
- la figure 3 est un diagramme illustrant l'évolution de la puissance optique émise par la diode électroluminescente en fonction du temps pour différents courants;
- la figure 4 est une vue en coupe schématique d'un exemple de diodes électroluminescentes de type puce commune (pour common chip en langue anglaise) ;
- la figure 5 illustre différentes étapes d'un exemple de procédé de prévision mis en oeuvre selon l'invention ;
- la figure 6 est un diagramme d'évolution du courant de fuite en fonction du temps de fonctionnement extrapolé de mesures pour un exemple de diode électroluminescente ;
- la figure 7 un diagramme d'évolution du courant de fuite en fonction du temps de fonctionnement extrapolé de mesures pour un autre exemple de diode électroluminescente.

Un autre mode de défaillance possible des diodes électroluminescentes est l'augmentation de courants de fuite et de courants non radiatifs. Les électrons constituant les courants de fuite ne sont pas recombinés de manière radiative dans la zone active de la LED. Les courants de fuite sont associés à des chemins de fuite en bord de puce, dans des zones dégradées de la zone active ou du fait d'imperfections de surface. Les courants non radiatifs correspondent à des courants qui génèrent de la chaleur et non de la lumière, par exemple du fait de défauts du semi-conducteur. Cet autre mode de défaillance se caractérise par un arrêt brutal de la diode électroluminescente.

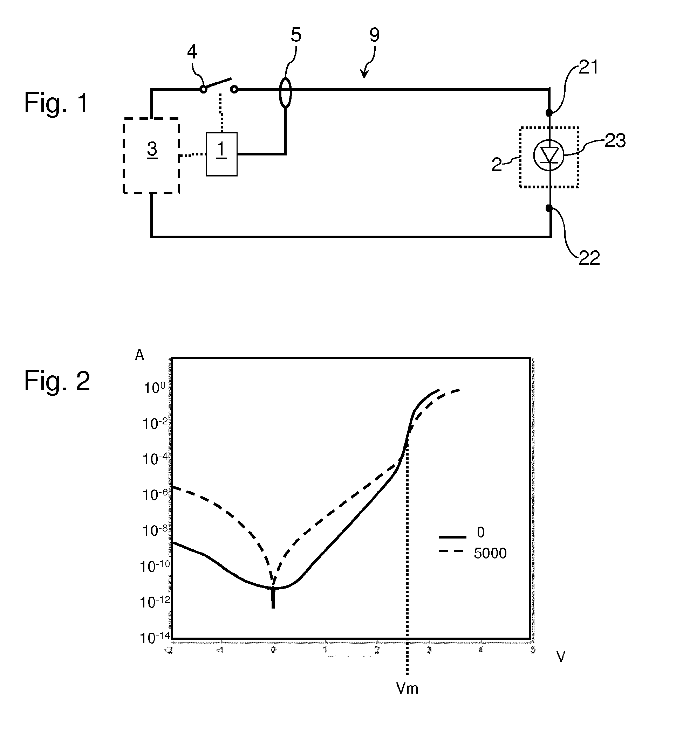

La figure 2 illustre un diagramme courant/tension d'un exemple de diode électroluminescente. Sur le diagramme, la courbe en trait plein définit le courant traversant une diode électroluminescente à sa mise en service, et la courbe en pointillés définit le courant traversant cette diode électroluminescente après 5000 heures d'allumage avec un courant nominal. La différence de potentiel Vₘ correspond à la tension minimale pour obtenir un allumage de la diode électroluminescente. On constate de façon générale que le courant traversant pour une polarisation inférieure à Vₘ augmente en fonction du temps.

L'invention propose d'appliquer une différence de potentiel de test aux bornes d'une diode électroluminescente, cette différence de potentiel de test étant inférieure à la différence de potentiel minimale d'allumage de cette diode électroluminescente et présentant le même signe que cette différence de potentiel minimale d'allumage. En mesurant le courant traversant par la diode électroluminescente durant l'application de la différence de potentiel de test, on peut générer un signal d'alerte lorsque ce courant traversant dépasse un seuil d'alerte.

Un tel procédé permet d'anticiper une future défaillance de la diode électroluminescente en fonctionnement avec une différence de potentiel d'allumage. La défaillance est ici anticipée non pas par des mesures en laboratoire mais par analyse de la diode électroluminescente en service en dehors d'une période d'allumage. Un tel résultat est obtenu sans nécessiter d'intégrer de capteur lumineux.

La figure 1 représente de façon schématique un dispositif d'éclairage 9 incluant un éclairage 2 incluant au moins une diode électroluminescente 23. La diode électroluminescente 23 peut par exemple être de type GaN. La diode électroluminescente 23 peut être alimentée de façon connue en soi par l'application d'une différence de potentiel appropriée entre des bornes 21 et 22.

Le dispositif d'éclairage 9 comporte à cet effet une alimentation électrique 3 destinée à appliquer sélectivement une différence de potentiel entre les bornes 21 et 22 de la diode électroluminescente 23. L'alimentation électrique 3 peut par exemple inclure un convertisseur fournissant une différence de potentiel continue sur sa sortie et inclure une source de tension connectée à l'entrée du convertisseur. L'alimentation électrique 3 est susceptible d'appliquer sélectivement sur sa sortie différente amplitudes de différences de potentiel, en fonction de signaux de commande. L'alimentation électrique 3 est notamment capable d'appliquer sur sa sortie d'une part une différence de potentiel de test inférieure à la différence de potentiel minimale d'allumage de la diode électroluminescente 23 et de même signe que cette différence potentiel minimale d'allumage, et d'autre part une différence de potentiel supérieure à cette différence de potentiel minimale d'allumage pour générer un éclairage par cette diode électroluminescente 23.

Le dispositif d'éclairage 9 comporte en outre un circuit de mesure 5 du courant traversant entre les bornes 21 et 22 de la diode électroluminescente 23. Le circuit de mesure 5 comporte par exemple une sonde de courant mesurant le courant d'une connexion électrique entre une des bornes 21 ou 22 et l'alimentation électrique 3.

Le dispositif d'éclairage 9 comporte ici facultativement un interrupteur 4 permettant sélectivement d'isoler la borne 21 de l'alimentation électrique 3.

Le dispositif d'éclairage 9 comporte un circuit de commande 1. Le circuit de commande 1 est configuré pour générer un signal de commande appliqué à l'alimentation électrique 3. Ce signal de commande définit le niveau de différence de potentiel appliquée sur la sortie de l'alimentation électrique 3. Le circuit de commande 1 est configuré pour récupérer une valeur de courant mesurée par le circuit de mesure 5. Le circuit de commande 1 est ici également configuré pour commander l'ouverture ou la fermeture de l'interrupteur 4.

Le circuit de commande 1 est notamment configuré pour appliquer un signal de commande sur l'alimentation électrique 3, de sorte que l'alimentation électrique 3 applique une différence de potentiel de test Vt entre les bornes 21 et 22. En désignant toujours par Vₘ la différence de potentiel minimale d'allumage de la diode électroluminescente 23 (fréquemment désignée par le terme de tension de seuil dans la littérature), la différence de potentiel de test Vt respecte l'inégalité Vt < Vₘ. Vₘ est typiquement d'environ 2,7V pour une diode électroluminescente bleue de type GaN. Le circuit de commande 1 récupère la valeur de courant I_{c} mesurée par le circuit de mesure 5 durant l'application de la différence de potentiel de test Vt. Le circuit de commande 1 compare cette valeur I_{c} à un seuil d'alerte Iₐ. Si I_{c} dépasse le seuil d'alerte Iₐ, le circuit de commande 1 génère un signal d'alerte. Ainsi, si I_{c} dépasse le seuil d'alerte Iₐ, on détermine que l'amplitude des courants de fuite devient significative et va prochainement conduire à une réduction sensible de l'intensité lumineuse émise par la diode électroluminescente lors de l'application d'une différence de potentiel d'allumage. En utilisant une différence de potentiel de test Vt inférieure à la différence de potentiel minimale d'allumage, on sait que le courant mesuré I_{c} ne participe pas du tout à l'éclairage de la diode électroluminescente 23, et donc le courant mesuré Ic est du courant « perdu » (somme du courant de fuite et des courants non radiatifs) directement représentatif du vieillissement de cette diode électroluminescente 23.

La génération du signal d'alerte peut servir soit à lancer un calcul de détermination d'une durée de vie résiduelle de la diode électroluminescente 23, soit à commander un transducteur pour la génération d'un signal perceptible par un opérateur.

La différence de potentiel de test Vₜ appliquée a le même signe que la différence de potentiel d'allumage de la diode électroluminescente 23. Ainsi, le courant traversant mesuré Ic est représentatif à la fois des courants de fuite et des courants non radiatifs. Le courant traversant Ic est ainsi mesuré dans des conditions très représentatives des conditions d'allumage dans lesquelles le dysfonctionnement est susceptible d'intervenir, contrairement à une différence de potentiel de test de signe opposé à une différence de potentiel d'allumage. Par ailleurs, une différence de potentiel de test du même signe qu'une différence de potentiel d'allumage permet de mesurer un courant traversant Ic présentant une amplitude relativement importante par rapport à un potentiel de test de signe opposé à une différence de potentiel d'allumage. La mesure du courant traversant Ic est ainsi peu beaucoup plus précise, facile à mesurer et moins sensible au bruit. Par ailleurs, la génération d'une différence de potentiel de test de même signe qu'une différence de potentiel d'allumage permet d'utiliser une alimentation électrique 3 dénuée d'un pont inverseur pour modifier la polarité de la différence de potentiel appliquée.

Avantageusement, la différence de potentiel de test Vₜ a une amplitude au moins égale à 70 % de la différence de potentiel minimale d'allumage (Vₘ). Ainsi, l'amplitude du courant mesuré I_{c} est plus importante, ce qui permet d'accroître encore la précision de la mesure et de se rapprocher davantage des conditions d'allumage durant le test. L'homme du métier peut également envisager d'appliquer une différence de potentiel de test plus basse, afin d'anticiper davantage l'apparition d'une défaillance.

Avantageusement, la différence de potentiel de test Vₜ est au plus égale à 90% de la différence de potentiel minimale d'allumage.

Le seuil d'alerte Iₐ pourra par exemple être fixé comme suit : Iₐ = n * Iₛ, avec Iₛ un courant d'utilisation et n un nombre compris entre 0,1 et 0,4.

L'invention peut également être mise en oeuvre pour prévoir une durée d'utilisation résiduelle de la diode électroluminescente 23, pour un courant d'utilisation donné. À cet effet, le dispositif d'éclairage 9 (par exemple le circuit de commande 1) peut mémoriser un courant nominal d'utilisation In de la diode électroluminescente ainsi qu'une loi du courant mesuré en test en fonction du vieillissement, de type I_{c}=f(t), avec t le temps d'utilisation de la diode électroluminescente 23 à son courant nominal d'utilisation Iₙ.

Le circuit de commande 1 récupère la mesure du courant I_{c}(t1), correspondant à une durée d'utilisation t1 au courant nominal d'utilisation.

A partir de la valeur I_{c}(t₁) et de la loi mémorisée I_{c}=f(t), on peut déterminer la durée de vie résiduelle T de la diode électroluminescente 23 en déterminant pour quelle valeur T on obtient I_{c}=f(t₁+T)=p*Iₙ, avec p un nombre avantageusement compris entre 0,1 et 0,4. On peut alors générer un signal d'alerte lorsque T devient inférieure à un seuil. On peut par exemple définir p pour que p*In soit égal au courant traversant la diode électroluminescente pour la différence de potentiel Vₘ.

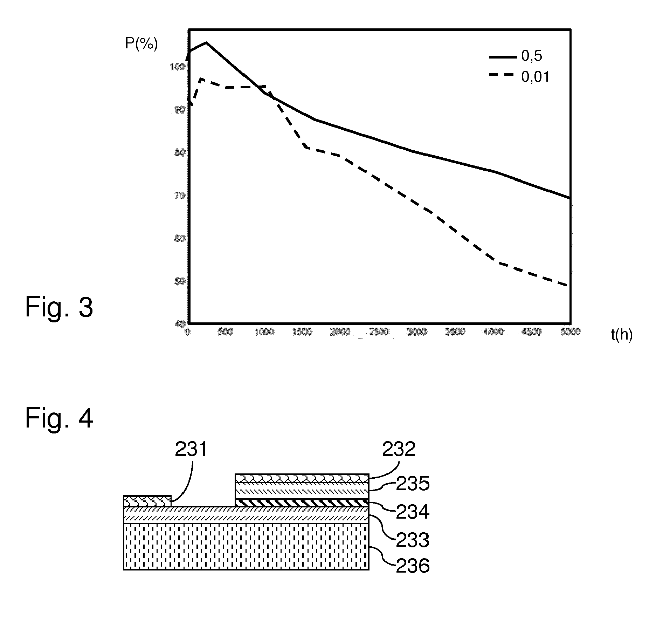

La figure 3 illustre un exemple de puissance d'illumination (en % de sa puissance initiale) d'une diode électroluminescente en fonction du temps d'allumage. La courbe en trait plein illustre la puissance d'illumination de la diode électroluminescente pour une différence de potentiel correspondant à un courant nominal de 500mA. La courbe en pointillés illustre la puissance d'illumination de la diode électroluminescente pour une différence de potentiel correspondant à un courant nominal de 10mA. On constate que le vieillissement est beaucoup plus sensible pour des courants nominaux réduits.

A partir d'un modèle de vieillissement (ici l'évolution de la puissance dans le temps dont on peut extrapoler Ic = f(t)) à un courant nominal donné tel qu'illustré à la figure 3 et à partir de la durée t1 déterminée précédemment, on peut également déterminer une durée de vie T après laquelle la puissance d'illumination à ce courant nominal sera inférieure à un seuil correspondant à un dysfonctionnement de la diode électroluminescente 21.

Le circuit de commande 1 est typiquement configuré pour générer des commandes, de sorte que la différence de potentiel appliquée par l'alimentation 3 en réponse à ces commandes corresponde à un courant nominal de la diode électroluminescente pour laquelle on dispose d'une loi de vieillissement.

On peut également envisager que le circuit de commande 1 mémorise des couples incluant un courant consommé pour la différence de potentiel de test et la durée de fonctionnement de la diode électroluminescente 23 au courant nominal. A partir de ces couples mémorisés, le circuit de commande 1 pourra déterminer une loi lc=f(t) spécifique pour la diode électroluminescente 23. Une telle détermination d'une loi sur la base des couples mémorisés pourra par exemple être réalisée sur la base d'approximations telles que les méthodes de moindres carrés, par rapport à des modèles tels que des modèles de variation linéaire, de variation exponentielle ou de polynômes.

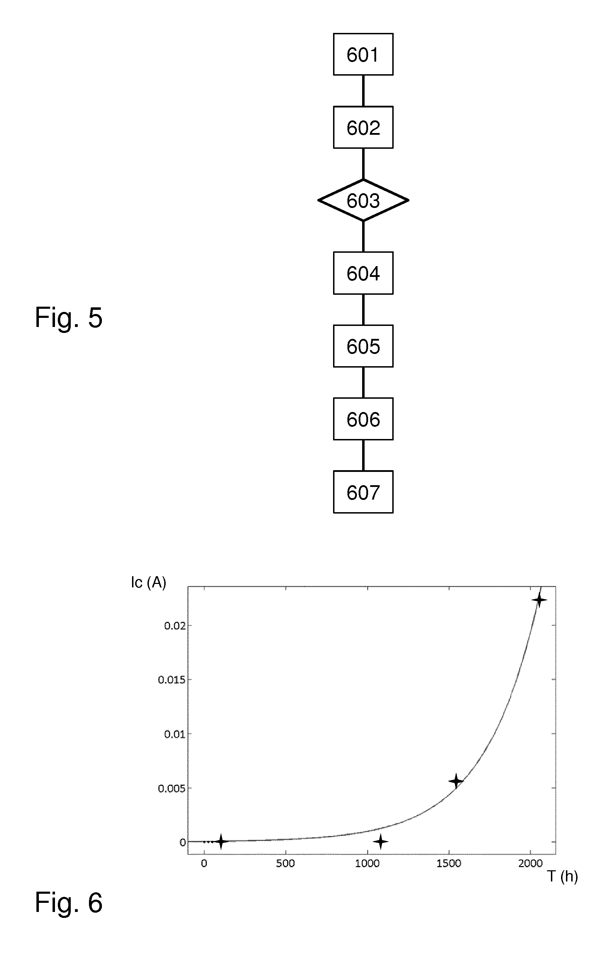

La figure 6 est un diagramme illustrant à la fois des points de mesure et une courbe extrapolée. Le diagramme illustre le courant Ic en fonction du temps, à une tension Vt de 2,4V, pour le modèle commercialisé sous la référence 'ES 18' par la société Edison. Le temps correspond à une durée de fonctionnement à 105°C à un courant de fonctionnement de 700mA. La courbe est ici extrapolée des points de mesure par l'intermédiaire d'une fonction exponentielle. La courbe extrapolée est ici extrêmement fidèle à la réalité, puisqu'on obtient un coefficient de détermination de 0,99 sur 1.

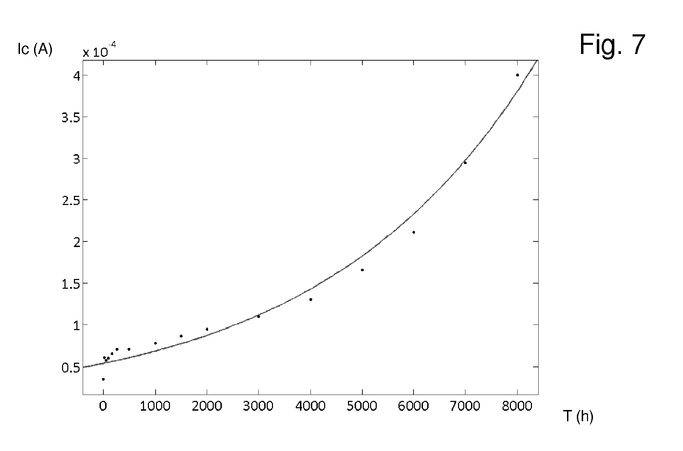

La figure 7 est un autre diagramme illustrant à la fois des points de mesure et une courbe extrapolée, pour un autre modèle de diode électroluminescente. Le diagramme illustre le courant Ic en fonction du temps, à une tension Vt de 2,4V, pour le modèle commercialisé sous la référence 'Rebel' par la société Lumileds. Le temps correspond à une durée de fonctionnement à 80°C à un courant de fonctionnement de 700mA. La courbe est ici extrapolée des points de mesure par l'intermédiaire d'une fonction exponentielle. La courbe extrapolée est ici extrêmement fidèle à la réalité, avec un coefficient de détermination également très élevé.

La figure 4 est une vue en coupe d'un exemple d'une diode électroluminescente. La diode électroluminescente est ici ménagée de façon connue en soi sur une couche de GaN 236. La diode électroluminescente comporte ici :
- une couche 233 de n-GaN (par exemple par dopage avec du silicium) ménagée sur la couche 236 ;
- une électrode 231 ménagée sur la couche 233 ;
- une couche active 234 ménagée sur la couche 233, de côté par rapport à l'électrode 231. La couche active 234 comprend généralement un empilement de couches de type InGa₍ₓ₋₁₎Nₓ ;
- une couche 235 de p-GaN (par exemple par dopage avec du magnesium) ;
- une électrode 232 ménagée sur la couche 235.

Le logigramme de la figure 5 définit différentes étapes d'un exemple de procédé de prévision de défaillance d'une diode électroluminescente. Lors d'une étape 601, on applique entre les bornes d'une diode électroluminescente une différence de potentiel de test inférieure à son potentiel d'allumage.

Lors d'une étape 602, on mesure le courant consommé par la diode électroluminescente durant l'application de la différence de potentiel de test.

Lors d'une étape 603, on détermine si le courant mesuré dépasse un seuil d'alerte prédéfini, par exemple lu dans une mémoire.

Lors d'une étape 604, on génère un signal d'alerte si le courant mesuré dépasse le seuil d'alerte prédéfini.

Lors d'une étape 605, on calcule une durée de vie résiduelle pour un courant nominal d'allumage de la diode électroluminescente.

Une loi de vieillissement de type Ic = f(t) peut être ajustée suite à des mesures effectuées sur la diode électroluminescente, en cours de vie. Une nouvelle loi de vieillissement Ic = f(tout) peut également être mémorisée suite à des mesures effectuées sur la diode électroluminescente, en cours de vie.

L'invention peut s'avérer particulièrement avantageuse dans différentes applications, par exemple pour la maintenance d'un parc de luminaires. Les signaux d'alerte permettent de réaliser par exemple des interventions de remplacement préventives de dispositifs d'éclairage susceptibles de devenir défaillants.

Dans l'exemple illustré, on a illustré une unique diode électroluminescente 23. L'invention s'applique bien entendu également à un éclairage 2 incluant de multiples diodes électroluminescentes connectées de façon connue en soi en série et/ou en parallèle.

Bien que l'invention s'avère particulièrement appropriée pour des diodes électroluminescentes présentant une architecture dite « latérale », l'invention s'applique à tout type de diodes électroluminescentes.

## Revendications

1. Procédé de prévision d'une défaillance d'une diode électroluminescente (23), comprenant les étapes de :
- appliquer (3) une différence de potentiel de test aux bornes de la diode électroluminescente (23) inférieure à sa différence de potentiel minimale d'allumage, ladite différence de potentiel de test ayant le même signe que la différence de potentiel minimale d'allumage de la diode électroluminescente;
- mesurer (5) le courant traversant I_{c} la diode électroluminescente (23) durant l'application de ladite différence de potentiel de test;
- générer un signal d'alerte lorsque le courant Ic mesuré dépasse un seuil d'alerte Iₐ.

2. Procédé de prévision selon la revendication 1, dans lequel ladite différence de potentiel de test a une amplitude au moins égale à 70% de la différence de potentiel minimale d'allumage.

3. Procédé de prévision selon la revendication 1 ou 2, dans lequel ladite différence de potentiel de test a une amplitude contrôlée.

4. Procédé de prévision selon l'une quelconque des revendications précédentes, dans lequel :
- on mémorise un courant nominal d'utilisation In de la diode électroluminescente et une loi de vieillissement du type I_{c}=f(t) avec t le temps d'utilisation de la diode électroluminescente à son courant nominal d'utilisation ;
- on mesure à un instant t1 le courant I_{c}(t₁) pour la différence de potentiel de test, et on détermine la durée de vie résiduelle T de la diode électroluminescente en déterminant pour quelle valeur T, on obtient I_{c}=f(t₁+T)=p*Iₙ, avec p un nombre compris entre 0,1 et 0,4 défini au préalable;
- on génère un signal d'alerte lorsque T devient inférieur à un seuil.

5. Procédé de prévision selon la revendication 3, dans lequel on mesure le courant Ic après différentes durées d'utilisation, on extrapole et on mémorise la loi de vieillissement Ic= f(t) en fonction desdites mesures de courant.

6. Procédé de prévision selon l'une quelconque des revendications précédentes, dans lequel le seuil la est égal à n*Iₛ, avec Iₛ un courant traversant la diode électroluminescente (23) pour une différence de potentiel supérieure à la différence de potentiel d'allumage, et n un nombre compris entre 0,1 et 0,4.

7. Dispositif d'éclairage (9), **caractérisé en ce qu'**il comprend :
- une diode électroluminescente (23) ;
- une alimentation électrique (3) connectée aux bornes de la diode électroluminescente (23) et susceptible d'appliquer sélectivement auxdites bornes, en fonction d'un signal de commande, une différence de potentiel supérieure à la différence de potentiel minimale d'allumage de la diode électroluminescente ou une différence de potentiel de test inférieure à la différence de potentiel minimale d'allumage de la diode électroluminescente, ladite différence de potentiel de test ayant le même signe que la différence de potentiel minimale d'allumage ;
- un circuit de mesure (5) du courant entre les bornes (21, 22) de la diode électroluminescente (23) ;
- un circuit (1) configuré pour générer un signal de commande commandant l'application de ladite différence de potentiel de test par l'alimentation électrique, et configuré pour générer un signal d'alerte lorsque le courant mesuré entre les bornes (21, 22) de la diode électroluminescente (23) pour ladite différence de potentiel de test dépasse un seuil d'alerte.

8. Dispositif d'éclairage (9) selon la revendication 7, dans laquelle ladite alimentation électrique (3) applique une différence de potentiel de test continue.

9. Dispositif d'éclairage (9) selon la revendication 8, dans lequel le circuit (1) est configuré pour mesurer le courant pour la différence de potentiel de test après différentes durées d'utilisation, et configuré pour extrapoler et mémoriser une loi de vieillissement de type Ic = f(t) en fonction desdites mesures de courant.

10. Dispositif d'éclairage (9) selon l'une quelconque des revendications 7 à 9, dans lequel ladite alimentation électrique (4) est configurée pour appliquer une différence de potentiel de test ayant une amplitude contrôlée.
